(19) Europäisches Patentamt
European Patent Office
Office européen des brevets

(11) EP 1 455 398 A2

(12) # EUROPEAN PATENT APPLICATION

(43) Date of publication:
08.09.2004 Bulletin 2004/37

(51) Int Cl.[7]: H01L 33/00

(21) Application number: 04005022.1

(22) Date of filing: 03.03.2004

(84) Designated Contracting States:
AT BE BG CH CY CZ DE DK EE ES FI FR GB GR HU IE IT LI LU MC NL PL PT RO SE SI SK TR
Designated Extension States:
AL LT LV MK

(30) Priority: 03.03.2003 JP 2003055851
14.03.2003 JP 2003069290

(71) Applicant: Toyoda Gosei Co., Ltd.
Nishikasugai-gun, Aichi-ken, 452-8564 (JP)

(72) Inventors:
- Suehiro, Yoshinobu c/o Toyoda Gosei Co.,Ltd. Nishikasugai-gun Aichi-ken, 452-8564 (JP)
- Inoue, Mitsuhiro c/o Toyoda Gosei Co.,Ltd. Nishikasugai-gun Aichi-ken, 452-8564 (JP)
- Kato, Hideaki c/o Toyoda Gosei Co.,Ltd. Nishikasugai-gun Aichi-ken, 452-8564 (JP)

(74) Representative: Vollnhals, Aurel
Tiedtke-Bühling-Kinne & Partner,
TBK-Patent,
Bavariaring 4
80336 München (DE)

(54) **Light emitting device comprising a phosphor layer and method of making same**

(57) A light emitting apparatus has: a semiconductor light emitting element that emits light with a predetermined wavelength; a light-transmitting portion that has a recess to house the semiconductor light emitting element, the light-transmitting portion being of a light-transmitting material and the recess being formed by molding the light-transmitting material; and a phosphor layer portion that is thinly formed along the surface of the recess, the phosphor portion having a phosphor to be excited by irradiating light emitted from the semiconductor light emitting element.

FIG.5A
1 LIGHT EMITTING APPARATUS
50 LED HOUSING RECESS
5A PHOSPHOR LAYER
5 LENS
3B WIRING PATTERN
3A WIRING PATTERN
2B LEAD
3 SUBMOUNT
4 LED
2A LEAD

EP 1 455 398 A2

## Description

The present application is based on Japanese patent application Nos.2003-055851 and 2003-069290, the entire contents of which are incorporated herein by reference.

## BACKGROUND OF THE INVENTION

### FIELD OF THE INVENTION

This invention relates to a light emitting apparatus that light radiated from a light emitting diode (herein referred to as LED) is absorbed in phosphor and light with a different wavelength is then radiated being wavelength-converted thereby and relates to a method of making the light emitting apparatus.

Also, this invention relates to a light emitting apparatus that light radiated from LED is radiated through an optical system in a predetermined direction and a predetermined range.

### DESCRIPTION OF THE RELATED ART

Japanese patent application laid-open No. 2000-077723 (herein referred to as prior art **1)** discloses a light emitting apparatus that light radiated from an LED chip is radiated being wavelength-converted by phosphor.

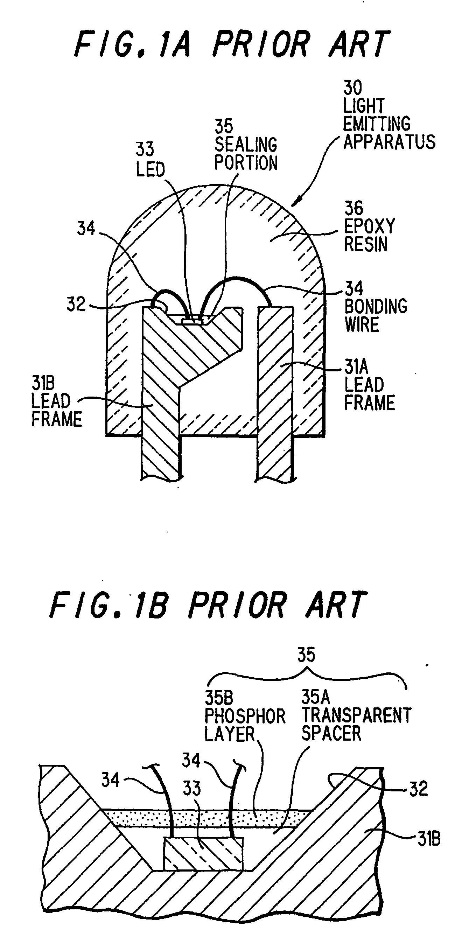

**FIG.1**A is a cross sectional view showing the light emitting apparatus disclosed in prior art **1.** The light emitting apparatus **30** is composed of: lead frames **31**A, **31**B; a cup **32** that is formed in the lead frame **31**A; LED **33** that is disposed in the cup **32;** bonding wires **34** that offer the electrical connection between electrodes of LED **33** and the lead frames **31**A, **31**B; a sealing portion **35** that seals LED **33** in the cup **32**; and epoxy resin **36** that seals the above elements and is shaped like a bullet lens.

**FIG.1**B is an enlarged cross sectional view showing the cup **32** and its vicinity. The sealing portion **35** is composed of a transparent spacer **35**A that is of ultraviolet curing resin and seals LED **33**, and a phosphor layer **35**B that is formed on the transparent spacer **35**A. In this composition, the phosphor layer **35**B can be evenly irradiated and, thereby, uniform lighting of white light can be conducted.

However, in the above composition, since the luminescence area of phosphor layer **35**B to radiate white light (wavelength-converted light) is nearly ten times that of LED **33**, white light radiated from the phosphor layer **35**B cannot be sufficiently converged by the converging optical system. Namely, since the phosphor layer **35**B has a luminescence area not so small compared to the size of converging optical system, the phosphor layer **35**B cannot be identified as a point light source thereto.

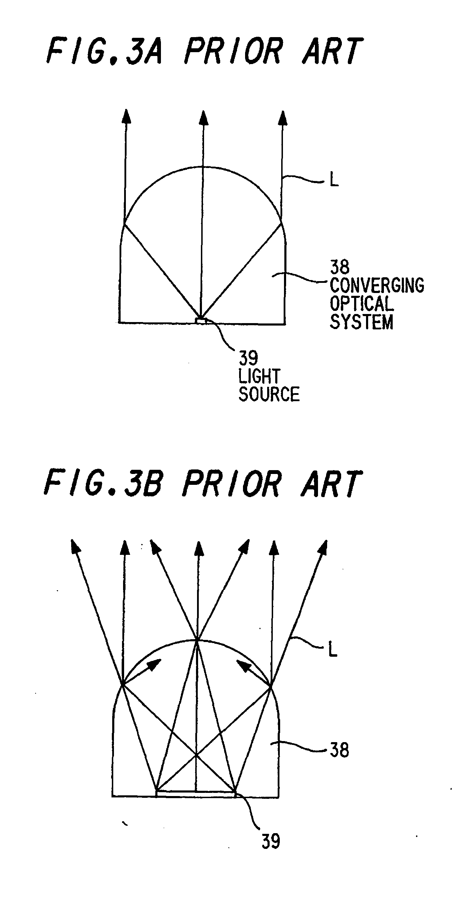

Namely, as shown in **FIG.3**A, when the luminescence area of light source **39** is so small compared to the size of converging optical system **38** and therefore it can be identified as a point light source, light L radiated from the light source **39** can be sufficiently converged by the converging optical system **38.** In contrast, as shown in **FIG.3**B, when the luminescence area of light source **39** is not so small compared to the size of converging optical system **38** and therefore it cannot be identified as a point light source, light L radiated from the light source **39** cannot be sufficiently converged by the converging optical system **38**. As a result, its convergence characteristic lowers. Due to the lowering of convergence characteristic, the light extraction efficiency of light emitting apparatus in a predetermined direction may lower.

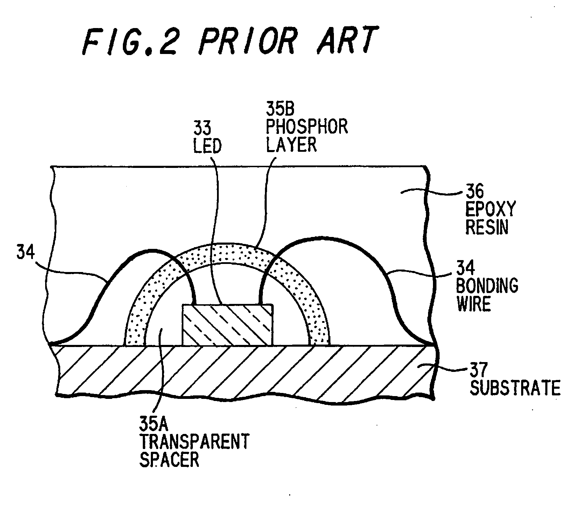

**FIG.2** is a cross sectional view showing part of a light emitting apparatus in modification of prior art **1**. In this modification, its light source is composed of LED **33** that is mounted on a substrate **37**; a semisphere transparent spacer **35**A that is of ultraviolet curing resin and seals LED **33**; and a phosphor layer **35**B that is formed on the transparent spacer **35**A and is of phosphor material.

However, since the transparent spacer **35**A and phosphor layer **35**B are formed by dropping ultraviolet curing resin or phosphor material, it is difficult to control the shape and thickness with a high precision. If the phosphor layer **35**B is formed thick locally, the light extraction efficiency may lower because light must be absorbed in such a local portion.

International publication No.99/09349 (herein referred to as prior art 2) discloses a light emitting apparatus that a LED chip is used as light source and an optical system is disposed close to the light source to reflect light radiated from the light source to a predetermined direction.

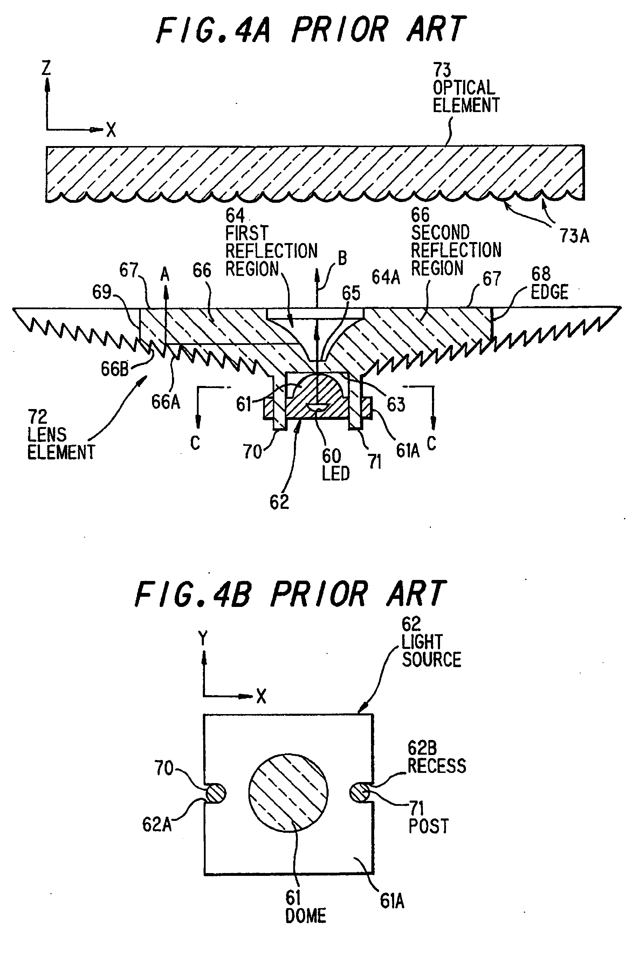

**FIG.4**A is a cross sectional view showing the light emitting apparatus disclosed in prior art **2. FIG.4**B is a cross sectional view cut along the line C-C in **FIG. 4**A.

The light emitting apparatus is, as shown in **FIG.4**A, composed of: a light emitting element **60** to radiate light; a light source **62** that has a dome portion **61** and a base portion **61**A formed integrated with the light emitting element **60**; a lens element **72** that is composed of an incident surface **63**, a first reflection region **64**, a first reflection surface **64**A, a direct light transmitting region **65**, second reflection region **66**, emission surface **67**, edges **68, 69** and posts **70, 71**; and an optical element **73** with pillow lens **73**A arrayed. The second reflection region **66** of lens element **72** has a plurality of pairs of extraction surface **66**A and step downs **66**B formed around the first reflection region **64.** The light source **62** is, as shown in **FIG.4**B, fixed such that that the dome portion **61** is positioned at the center of first reflection region **64** by engaging recesses **62**A, **62**B of the base portion **61**A to the posts **70, 71** of lens element **72**.

In operation, light radiated from the light source **62** is entered through the incident surface **63** into the lens element **72.** Part of this light is reflected by the first reflection surface **64**A in the direction vertical to the center axis of light source **62,** reflected by the extraction surface **66**A in the direction of center axis, irradiated as light A through the emission surface **67** to the optical element **73**. The other part of light is transmitted through the direct light transmitting region **65** in the direction of center axis, irradiated as light B to the optical element **73**. Thus, the optical element **73** can radiate light with an enlarged lighting range.

However, the light emitting apparatus of prior art **2** has a problem that it must have an increased thickness since the dome portion **61** is provided as a separate body from the lens element **72**.

Further, since the light source **62** and lens element **72** are individually manufactured and positioned by using the posts **70, 71** and recesses **62**A, **62**B (positioning means), the positioning precision depends on a precision in manufacturing the positioning means. In other words, if the manufacturing precision of positioning means is low, the positioning precision cannot be adjusted in assembling them.

Further, since part of light laterally radiated cannot be converged in the direction of center axis, the light extraction efficiency may lower.

Also in the light emitting apparatus of prior art **2**, the light emitting element **60** (light source) cannot be identified as a point light source since it is not so small compared to the size of dome **61** (converging optical system). As described earlier, light L cannot be sufficiently converged and, thereby, the convergence characteristic lowers. Due to the lowering of convergence characteristic, the light extraction efficiency of light emitting apparatus in the direction of center axis may lower.

## SUMMARY OF THE INVENTION

It is an object of the invention to provide a light emitting apparatus that has an enhanced extraction efficiency of white light to be radiated from phosphor layer.

It is another object of the invention to provide a light emitting apparatus that has an enhanced extraction efficiency of light while having a reduced thickness.

It is a further object of the invention to provide a method of making a light emitting apparatus that the shape and thickness of phosphor layer can be controlled with high precision.

It is a further object of the invention to provide a method of making a light emitting apparatus that the positioning precision in assembling can be easily adjusted.

(**1**) According to first aspect of the invention, a light emitting apparatus comprises:

a semiconductor light emitting element that emits light with a predetermined wavelength;
a light-transmitting portion that includes a recess to house the semiconductor light emitting element, the light-transmitting portion being of a light-transmitting material and the recess being formed by molding the light-transmitting material; and
a phosphor layer portion that is thinly formed along the surface of the recess, the phosphor portion including a phosphor to be excited by irradiating light emitted from the semiconductor light emitting element.

(**2**) According to second aspect of the invention, a method of making a light emitting apparatus comprises the steps of:

preparing a light-transmitting portion that includes a recess to house a semiconductor light emitting element, the light-transmitting portion being of a light-transmitting material and the recess being formed by molding the light-transmitting material, the recess being provided with a phosphor layer that is thinly formed along the surface of the recess;
forming an electrode of metal material;
mounting the semiconductor light emitting element on the electrode;
positioning the light-transmitting portion to the electrode; and
bonding the light-transmitting portion onto the electrode such that the phosphor layer of the recess surrounds the semiconductor light emitting element.

(**3**) According to third aspect of the invention, a light emitting apparatus comprises:

a light emitting element;
a power supply portion to supply electric power to the light emitting element;
a first optical system that is formed in a range of a predetermined angle to the center axis of the light emitting element when determining the center of emission surface of the light emitting element as origin point; and
a second optical system that includes a reflection plane disposed facing the emission surface of the light emitting element and a radiation face to externally radiate light being emitted from the light emitting element and then reflected on the reflection plane;

wherein the first optical system and the second optical system are disposed such that light being emitted from the light emitting element is externally radiated in the direction vertical to the center axis of the light emitting element.

(**4**) According to fourth aspect of the invention, a method of making a light emitting apparatus comprises the steps of:

forming a power supply portion;
mounting a light emitting element on the power supply portion;
positioning an optical system to the power supply portion, the optical system being composed of a first optical system that includes a recess to house the light emitting element and a convergence surface to converge light emitted from the light emitting element and then radiate it in the direction vertical to the center axis of the light emitting element, and a second optical system that includes a reflection plane to allow the total reflection of light emitted from the light emitting element and then radiate it in the direction vertical to the center axis of the light emitting element; and
bonding the optical system onto the power supply portion such that the light emitting element is surrounded by the recess.

(**5**) According to fifth aspect of the invention, a light emitting apparatus comprises:

a light emitting element;
a power supply portion to supply electric power to the light emitting element; and
an optical system that includes a recess to house the light emitting element, a light-guiding portion to guide light emitted from the light emitting element in the direction vertical to the center axis of the light emitting element, and a reflection portion to reflect light being guided through the light-guiding portion in the direction vertical to the center axis and then radiate it in the direction parallel to the center axis.

## BRIEF DESCRIPTION OF THE DRAWINGS

The preferred embodiments according to the invention will be explained below referring to the drawings, wherein:

**FIG.1**A is a cross sectional view showing the light emitting apparatus disclosed in prior art **1;**
**FIG.1**B is an enlarged cross sectional view showing the cup **32** and its vicinity in **FIG.1**A;
**FIG.2** is a cross sectional view showing part of a light emitting apparatus in modification of prior art **1**;
**FIG.3**A is an illustration showing a convergence characteristic in case of a light source of relatively small size;
**FIG.3**B is an illustration showing a convergence characteristic in case of a light source of relatively large size;
**FIG.4**A is a cross sectional view showing the light emitting apparatus disclosed in prior art **2**;
**FIG.4**B is a cross sectional view cut along the line C-C in **FIG.4**A;

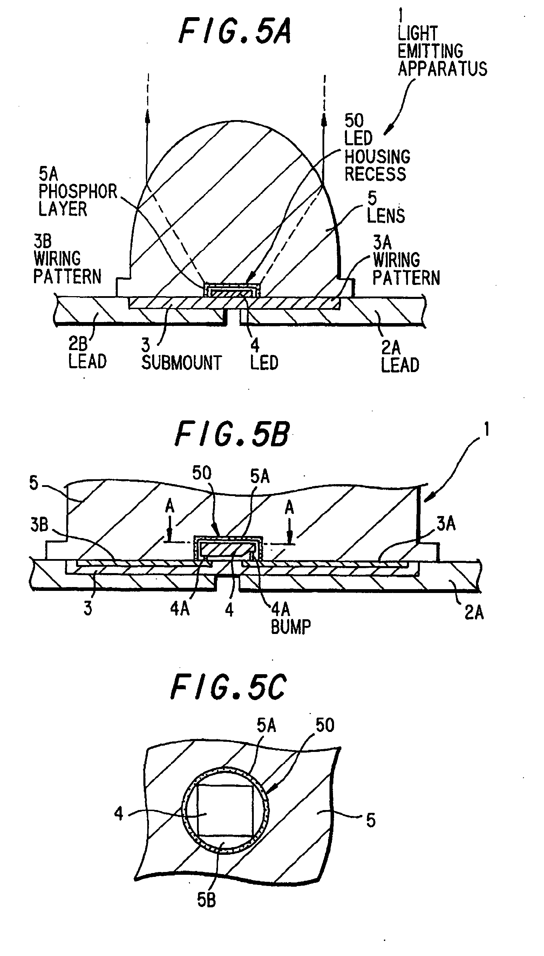

**FIG.5**A is a cross sectional view showing a light emitting apparatus in a first preferred embodiment of the invention;
**FIG.5**B is a partial enlarged cross sectional view showing LED **4** and its vicinity in **FIG.5**A;
**FIG.5**C is a cross sectional view cut along the line A-A in **FIG.5**B;

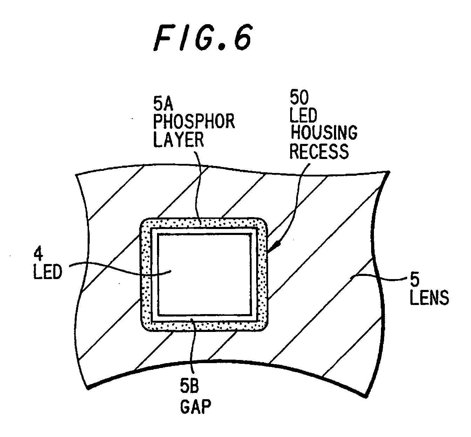

**FIG.6** is a horizontal cross sectional view showing part of a light emitting apparatus in a second preferred embodiment of the invention;

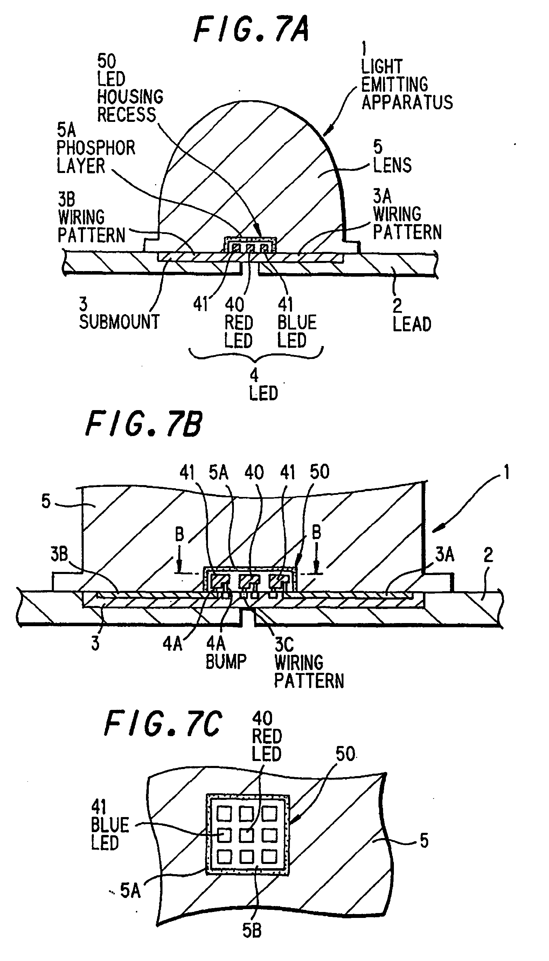

**FIG.7**A is a cross sectional view showing a light emitting apparatus in a third preferred embodiment of the invention;
**FIG.7**B is an enlarged cross sectional view showing an LED element **4** and its vicinity in **FIG.7**A;
**FIG.7**C is a horizontal cross sectional view cut along the line B-B in **FIG.7**B;

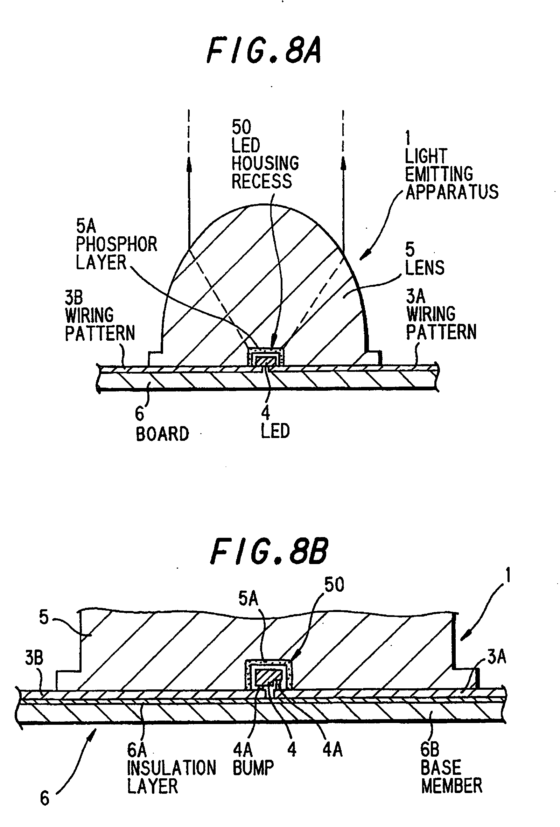

**FIG.8**A is a cross sectional view showing a light emitting apparatus in a fourth preferred embodiment of the invention;
**FIG.8**B is an enlarged cross sectional view showing an LED **4** and its vicinity in **FIG.8**A;

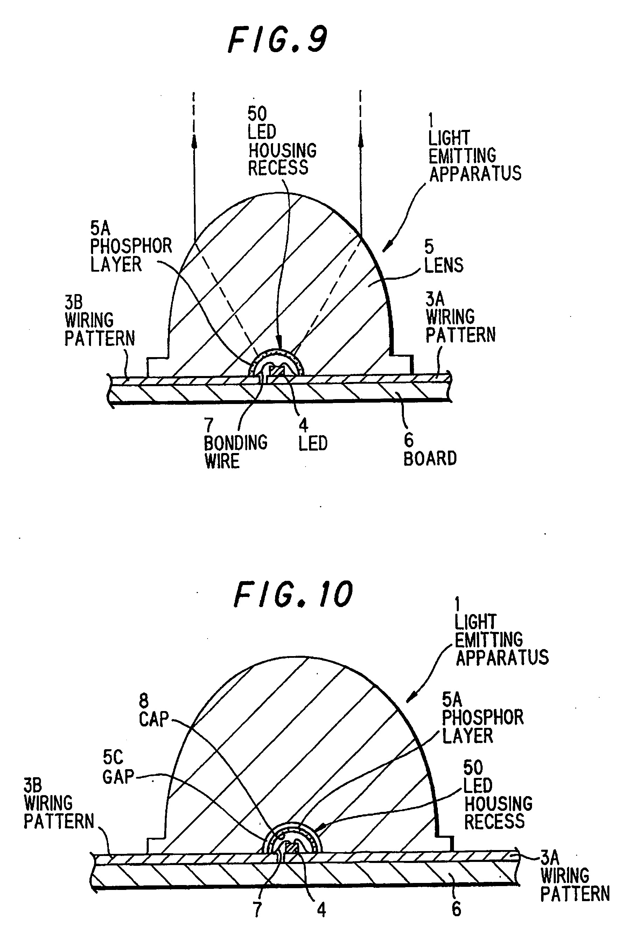

**FIG.9** is a cross sectional view showing a light emitting apparatus in a fifth preferred embodiment of the invention;
**FIG.10** is a cross sectional view showing a light emitting apparatus in a sixth preferred embodiment of the invention;

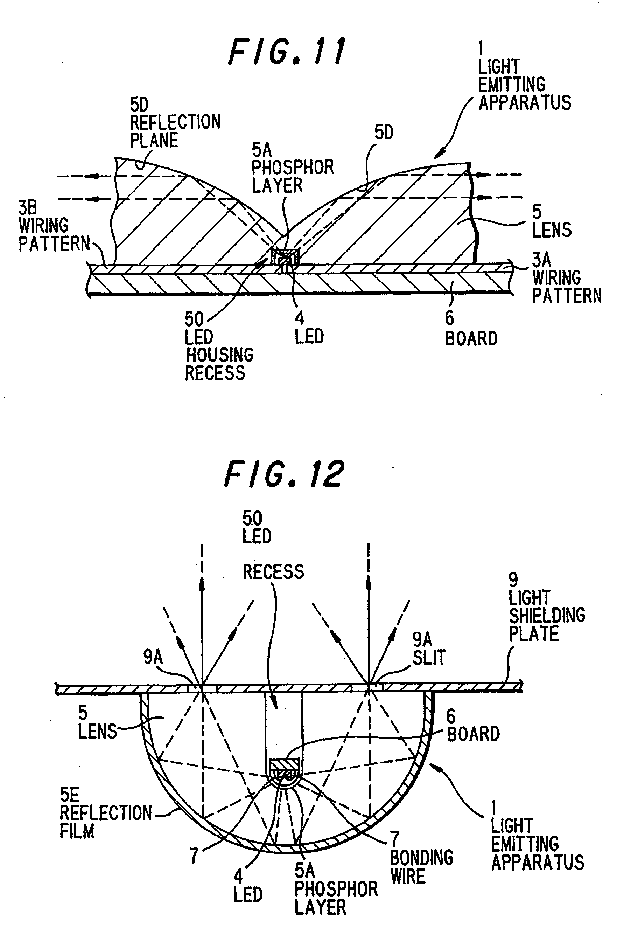

**FIG.11** is a cross sectional view showing a light emitting apparatus in a seventh preferred embodiment of the invention;
**FIG.12** is a cross sectional view showing a light emitting apparatus in an eighth preferred embodiment of the invention;

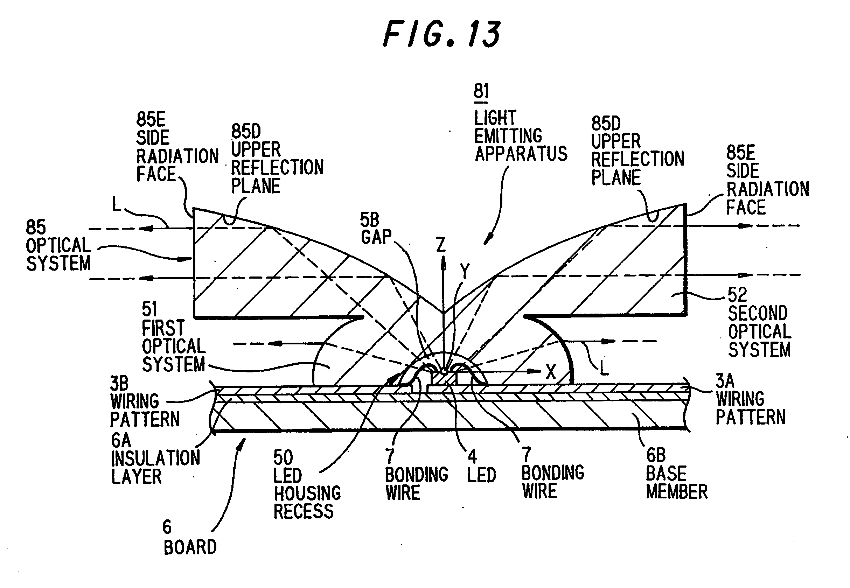

**FIG.13** is a cross sectional view showing a light emitting apparatus in a ninth preferred embodiment of the invention;

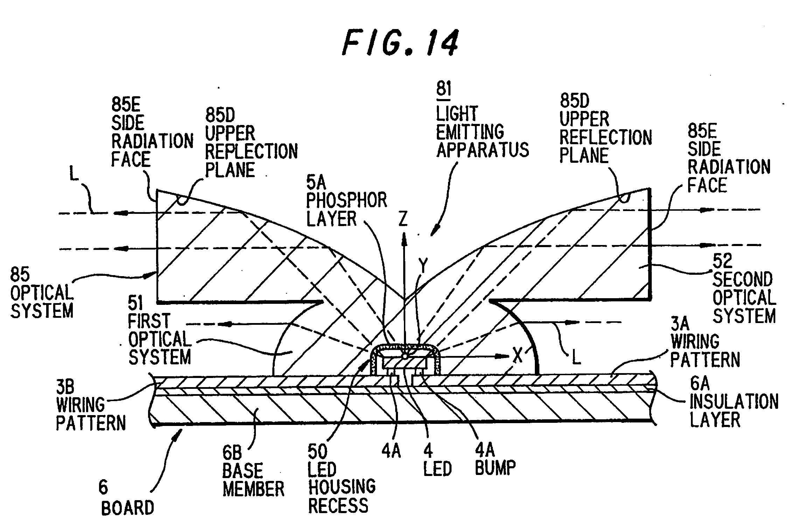

**FIG.14** is a cross sectional view showing a light emitting apparatus in a tenth preferred embodiment of the invention;

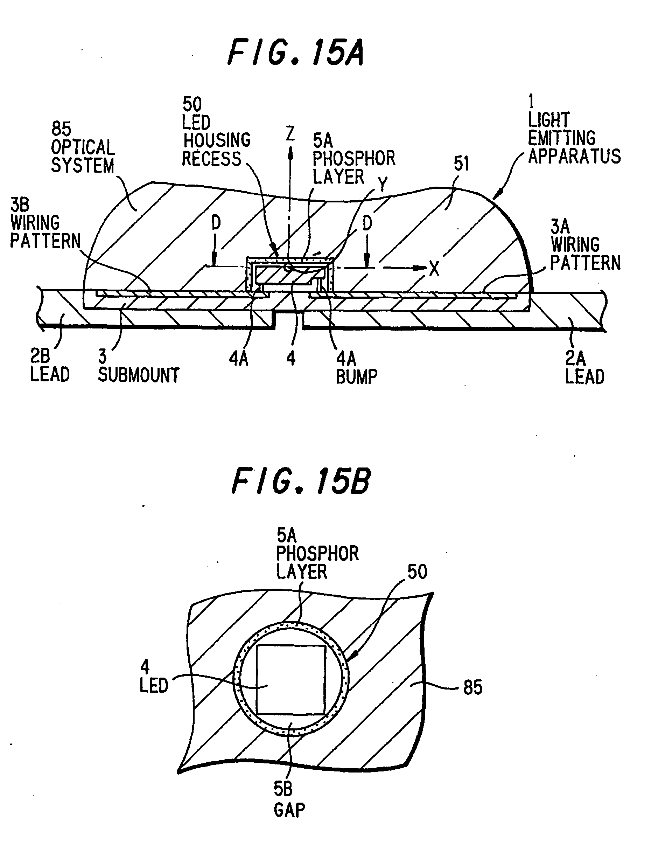

**FIG.15**A is a cross sectional view showing part of a light emitting apparatus in an eleventh embodiment of the invention;
**FIG.15**B is a cross sectional view cut along the line D-D in **FIG.15**A;

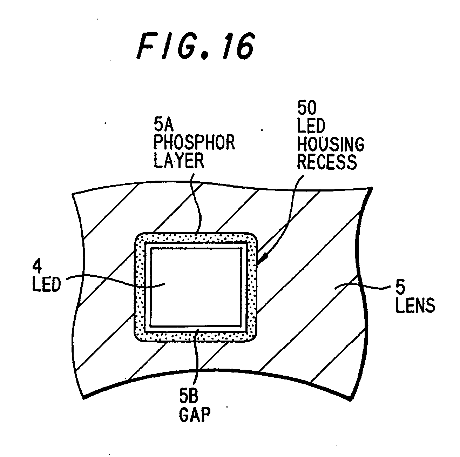

**FIG.16** is a cross sectional view showing an LED housing recess **50** of a light emitting apparatus in a twelfth preferred embodiment of the invention;

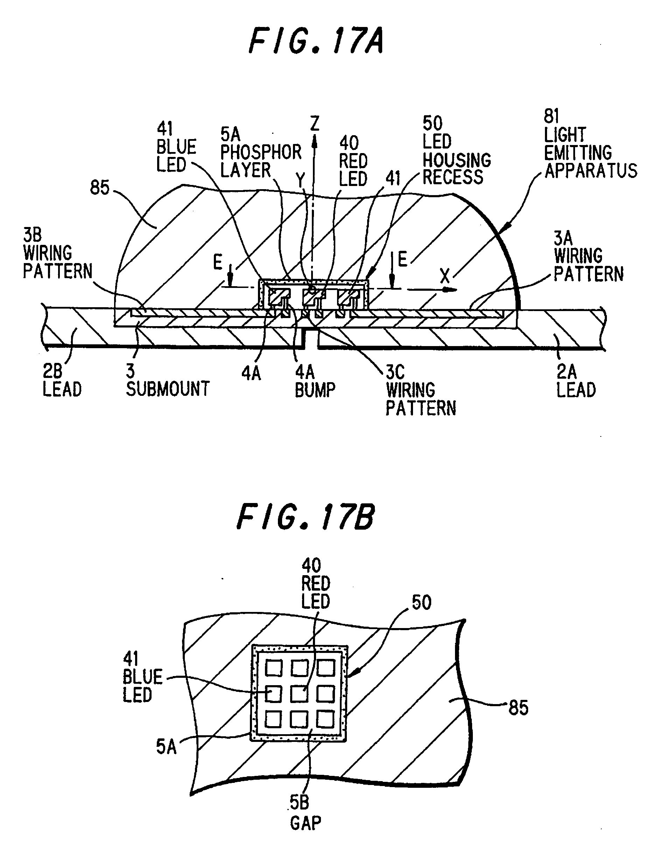

**FIG.17**A is a cross sectional view showing part of a light emitting apparatus in a thirteenth preferred embodiment of the invention;
**FIG.17**B is a cross sectional view cut along the line E-E in **FIG.17**A;

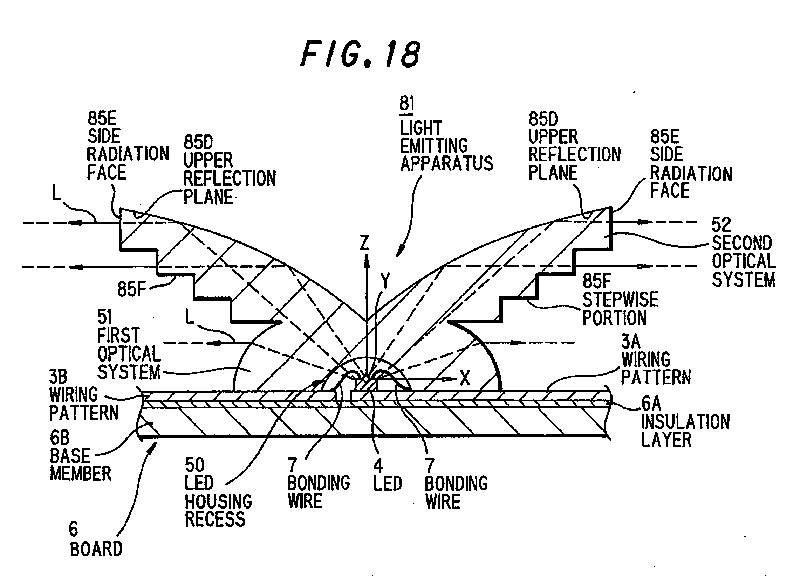

**FIG. 18** is a cross sectional view showing a light emitting apparatus in a fourteenth preferred embodiment of the invention;

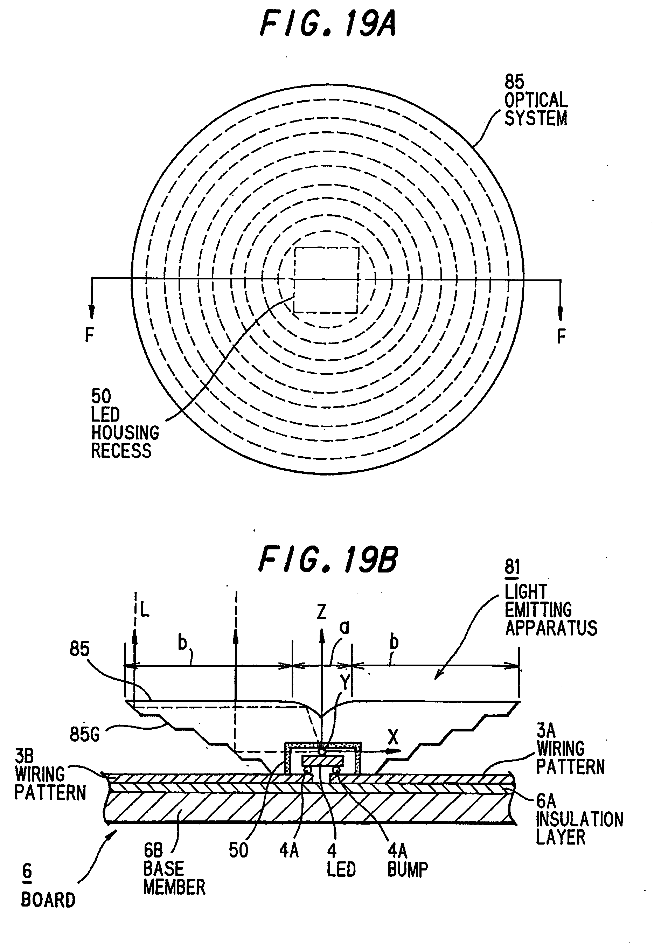

**FIG.19**A is a top view showing a light emitting apparatus in a fifteenth preferred embodiment of the invention;

**FIG.19**B is a cross sectional view cut along the line F-F in **FIG.19**A;

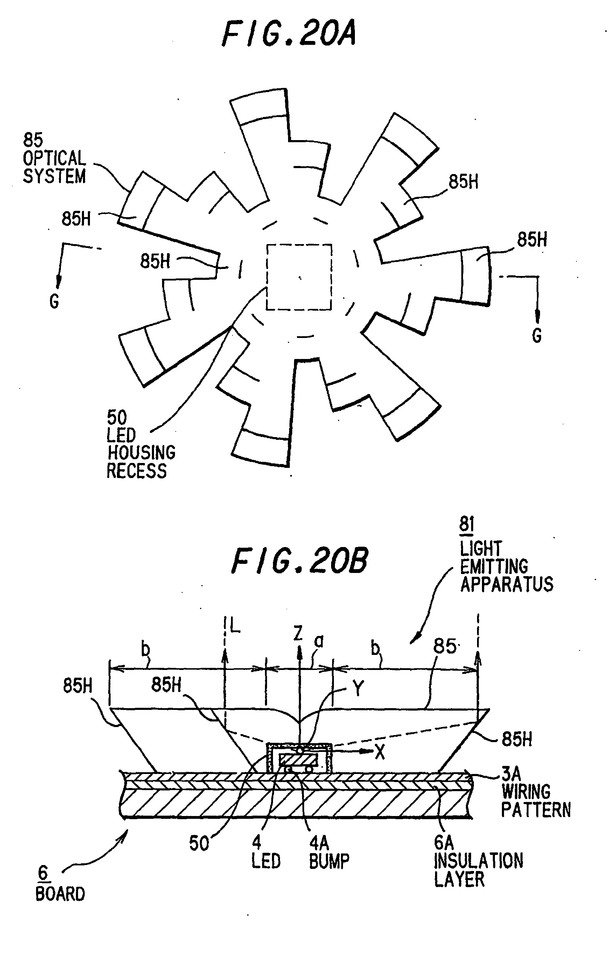

**FIG.20**A is a top view showing a light emitting apparatus in a sixteenth preferred embodiment of the invention; and

**FIG.20**B is a cross sectional view cut along the line G-G in **FIG.20**A.

## DETAILED DESCRIPTION OF THE PREFERRED EMBODIMENTS

### [First Embodiment]

**FIG.5**A is a cross sectional view showing a light emitting apparatus in the first preferred embodiment of the invention. **FIG.5**B is a partial enlarged cross sectional view showing LED **4** in **FIG.5**A and its vicinity. **FIG.5**C is a cross sectional view cut along the line A-A in **FIG.5**B.

In the below explanation, a term "convergence (or converging)" means, including to converge light like a spot in the direction of optical axis of LED, to converge light in the direction vertical to the optical axis of LED and to converge light in the direction of a predetermined angle to the optical axis of LED.

As shown in **FIG.5**A**,** the light emitting apparatus **1** is composed of: leads **2**A, **2**B that are of metal material; a submount **3** that is provided on the LED-mounting side of leads **2**A, **2**B and has wiring patterns **3**A, **3**B provided on its surface; an LED element **4** that is mounted on the wiring patterns **3**A, **3**B; a lens **5** that is bonded to the leads **2**A, **2**B while surrounding the LED element **4**.

The submount **3** is of a material with high thermal conductivity, such as AlN. The LED element **4** is flip-chip bonded through bumps **4**A onto the wiring patterns **3**A and **3**B formed on the submount **3**. The wiring pattern **3**A is electrically connected through a viahole (not shown) to the lead **2**A, and the wiring pattern **3**B is electrically connected through a viahole (not shown) to the lead **2**B.

The LED element **4** is of a gallium nitride system compound semiconductor such as GaN, GaAlN, InGaN, InGaAlN etc. or ZnSe and emits blue series light with a wavelength of **450** to **480** nm. The LED element **4** mainly emits light from the side of sapphire substrate disposed on the back side of its electrode forming surface, and it has a chip size of **1000**x**1000** μm. The device structure of blue LED is well known and its explanation is omitted herein.

The lens **5** is shaped like a bullet by injection-molding transparent resin such as epoxy resin, and it is positioned at a predetermined position to the leads **2**A, **2**B on which the LED element **4** is mounted. Although not shown, the positioning is conducted such that concave portions on the leads **2**A, **2**B are engaged with convex portions on the lens **5.** Alternatively, another positioning method may be used.

The lens **5** is, as shown in **FIG.5**B, has a LED housing recess **50** that houses the LED element **4** when the lens **5** is positioned to the leads **2**A, **2**B. The LED housing recess **50** has a phosphor layer **5**A formed on its surface. The LED housing recess **50**, as shown in **FIG.5**C, has such a size that a gap **5**B between the LED housing recess **50** and the LED element **4** can be minimized. The phosphor layer **5**A is of Ce:YAG (yttrium aluminum garnet) to be excited by blue light above-mentioned and thereby to radiate yellow light.

In manufacturing the light emitting apparatus **1** thus composed, the leads **2**A, **2**B are formed by punching a metal member. In the process of forming the leads **2**A, **2**B by punching, the concave portions for positioning are simultaneously formed by indentation method. Then, the submount **3** of a high thermal conductivity material is disposed on the device-mounting side of leads **2**A, **2**B. Then, the circuit patterns **3**A, **3**B of copper foil is formed on the surface of submount **3.** Then, the LED element **4** is flip-chip bonded through the bumps **4**A to the circuit patterns **3**A, **3**B while being positioned at a predetermined position thereof.

The lens **5** is made in separate process. First, by filling transparent resin in a mold with a shape of the lens **5**, a bullet-shaped lens **5** with the LED housing recess **50** is made by injection-molding. In the process of injection molding, the concave portions for positioning are simultaneously molded. Then, the phosphor layer **5**A is formed on the surface of LED housing recess **50** by coating thinly phosphor material.

Then, the lens **5** is positioned such that the convex portions are engaged with the concave portions on the leads **2**A, **2**B. At that time, the LED housing recess **50** of the lens **5** is filled with transparent silicon resin injected thereinto. Then, the lens **5** is fixed on the leads **2**A, **2**B while sealing the LED element **4** with silicon resin.

The operation of the light emitting apparatus of the first embodiment will be described below.

A drive section (not shown) applies a drive voltage to the leads **2**A, **2**B. The LED element **4** emits blue light based on the drive voltage. Blue light emitted from the LED element **4** is irradiated to the phosphor layer **5**A. The phosphor layer **5**A is excited by blue light and radiates yellow light. Blue light is mixed with blue light in the phosphor layer **5**A and, thereby, white light is generated. White light thus generated is entered into the lens **5,** converged by the bullet-shaped lens **5,** then radiated out of the lens **5.** Thus, white light radiated is converged in a predetermined lighting range while having a homothetic ratio to be determined by the size of light source and the shape of optical system.

The effects obtained in the first embodiment are as follows.

(**1**) Since the external lens **5** is provided with the LED housing recess **50** and it is closely disposed surrounding the LED element **4** while providing the surface of LED housing recess **50** with the phosphor layer **5**A, the phosphor layer **5**A can be formed as a uniform and thin layer. With the uniform and thin phosphor layer **5**A, the lowering of light intensity due to light absorption can be prevented. Also, since the size of light source can be minimized substantially without being influenced by the thickness of phosphor layer **5**A, light radiated from the light source can be sufficiently converged like a spot by the converging optical system. Thereby, the light intensity in a predetermined lighting range can be increased.

(**2**) Even when a large size LED element **4** (e.g., **1000** μm square) is used, a good convergence characteristic can be secured while suppressing the enlargement of light source size caused by covering the light source with phosphor layer **5**A.

(**3**) Since the lens **5** is manufactured separately from the leads **2**A, **2**B with the LED element **4** mounted thereon, the LED element **4** on the leads **2**A, **2**B can be precisely positioned to the phosphor layer **5**A of lens **5.** Therefore, light radiated from the light source can be adjustably converged in a desired lighting direction and in a desired lighting range. Further, the shape of lens **5** can be optioned according to intended usage and convergence characteristic.

(**4**) In the method of forming the phosphor layer **5**A on the surface of LED housing recess **50** of lens **5**, the way of forming a uniform and thin phosphor layer can be optioned. Therefore, the manufacturing cost can be reduced especially when an expensive phosphor material is needed to use since the amount used can be lowered.

(**5**) Since the LED element **4** is mounted on the leads **2**A, **2**B through the submount **3** with high thermal conductivity, the radiation property can be enhanced. Therefore, the light emitting apparatus thus composed can efficiently fulfill the requirement of large output for increased light intensity.

**[Second Embodiment]**

**FIG.6** is a horizontal cross sectional view showing part of a light emitting apparatus in the second preferred embodiment of the invention. Like components are indicated by the same numerals used in the first embodiment and the explanations are omitted below.

In the second embodiment, The LED housing recess **50** of lens **5** surrounding the LED element **4** is formed such that it has a rectangular shape similar to the shape of LED element **4.** A gap between the LED element **4** and the phosphor layer **5A** is further narrowed and, therefore the enlargement of light source size can be more effectively suppressed and the convergence characteristic of light radiated can be further enhanced.

**[Third Embodiment]**

**FIG.7**A is a cross sectional view showing a light emitting apparatus in the third preferred embodiment of the invention. **FIG.7**B is an enlarged cross sectional view showing an LED element **4** (red LED element **40** and blue LED element **41**) and its vicinity. **FIG.7**C is a horizontal cross sectional view cut along the line B-B in **FIG.7**B.

The light emitting apparatus **1** is composed of the LED element **4** that is mounted disposed at the wiring patterns **3**A, **3**B and **3**C, respectively, formed on the submount **3** and a lens **5** that is bonded onto the leads **2**A, **2**B while surrounding the LED element **4**.

The LED element **4** is, as shown in **FIG.7**C, composed of a red LED element **40** to emit red light and eight blue LED elements **41** disposed around the red LED element **40** that are flip-chip bonded to the wiring patterns **3**A, **3**B and **3**C. The LED elements **40, 41** each have a chip size of **300**x**300** μm.

The phosphor layer **5**A is of Ce:YAG to be excited by blue light radiated from the blue LED element **41** and thereby to radiate yellow light.

In the third embodiment, the color rendering property can be enhanced since red light radiated from the red LED element **40** is added to white light that is obtained by mixing blue light radiated from the blue LED element **41** with yellow light radiated from the phosphor layer **5**A to be excited by that blue light.

Alternatively, ultraviolet LED elements may be disposed around the red LED element **40** instead of blue LED elements **41** while using a phosphor layer **5**A including red, blue and green phosphors. Thus, by entering ultraviolet light into such a phosphor layer **5**A, white light can be obtained. Further, without using the red LED element **40,** nine blue LED elements **41** may be disposed.

The LED housing recess **50** may be provided with a light diffusion layer on the surface as well as the phosphor layer **5**A, so that light radiated from the LED element **4** can be diffused by the light diffusion layer. Thereby, a plurality of LED elements can approximate a continuous light source and the light source can be downsized.

**[Fourth Embodiment]**

**FIG.8**A is a cross sectional view showing a light emitting apparatus in the fourth preferred embodiment of the invention. **FIG.8**B is an enlarged cross sectional view showing an LED **4** and its vicinity in **FIG.8**A.

The light emitting apparatus **1,** as shown in **FIGS.8**A and **8**B, employs a board **6** that is composed of: an insulation layer **6**A; a base member **6**B of excellent thermal conductivity material such as aluminum; and wiring patterns **3**A, **3**B of copper foil etc. provided on the surface of insulation layer **6**A. The difference of the fourth embodiment from the first embodiment is that the LED element **4** of **300**x**300** μm, which is smaller than the LED element **4** in the first embodiment, is flip-chip bonded onto the wiring patterns **3**A, **3**B**.**

In the fourth embodiment, since the substrate **6** has an excellent heat radiation property, heat from the LED element **4** when turned on can be efficiently radiated through the board **6**. Therefore, it can be applied to a high-output LED **4**.

Further, since the thickness of phosphor layer **5**A can be thinned even when the LED element **4** is downsized, the shielding of light due to the phosphor layer **5**A can be avoided.

Still further, with such a small LED element **4,** light generated can be converged into a smaller spot by the converging optical system. Thus, the light intensity in a predetermined lighting range can be enhanced.

**[Fifth Embodiment]**

**FIG.9** is a cross sectional view showing a light emitting apparatus in the fifth preferred embodiment of the invention.

The light emitting apparatus **1** is structured such that an LED element **4** of **300**x**300** μm is face-up bonded onto the wiring pattern **3**A provided on the board **6** explained in the fourth embodiment, and the electrodes of LED element **4** are electrically connected through bonding wires **7** to the wiring patterns **3**A, **3**B.

The lens **5** has a LED housing recess **50** that is shaped like a dome to surround the LED element **4** and bonding wires **7,** and the LED housing recess **50** has a thin phosphor layer **5**A on its surface. The inside of LED housing recess **50** is filled with transparent silicon resin (not shown) injected thereinto.

In the fifth embodiment, the enlargement of light source size can be suppressed even when the LED element **4** is face-up bonded. Therefore, the convergence characteristic as well as the light intensity can be enhanced. The dome shape of LED housing recess **50** is preferably formed to have a minimum radius while allowing the protection of the bonding wires **7**. for example, it may be formed into a cone.

Although in the above embodiments the thin phosphor layer **5**A is formed on the surface of LED housing recess **50** of the lens **5**, the phosphor layer **5**A may be formed independently of the lens **5** if it can be made sufficiently thin.

**[Sixth Embodiment]**

**FIG.10** is a cross sectional view showing a light emitting apparatus in the sixth preferred embodiment of the invention.

The light emitting apparatus **1** is composed of: an LED element **4** that is face-up bonded onto the wiring patterns **3**A, **3**B of board **6**; a cap **8** that is of transparent resin and made independently of the lens **5** to surround the LED element **4** like a dome; and a phosphor layer **5**A that is thinly formed on the outer surface of the cap **8.** The lens **5** is integrated with the board **6** while having a gap **5**C lying between the LED housing recess **50** and the phosphor layer **5**A. The inside of cap **8** is filled with transparent silicon resin injected thereinto.

In the sixth embodiment, the lens **5** is made independently of the phosphor layer **5**A. Therefore, it is easy to control the thickness of phosphor layer **5**A in forming the phosphor layer **5**A on the outer surface of cap **8**. The shape of cap **8** is not limited to a dome as shown in **FIG.10** and may be, for example, a rectangle that can house an LED element **4** flip-chip bonded.

Although this embodiment is applied to the converging optical system that converges light in the optical axis direction of light source, it may be applied to a converging optical system that converges light in the direction vertical to the optical axis of light source.

**[Seventh Embodiment]**

**FIG.11** is a cross sectional view showing a light emitting apparatus in the seventh preferred embodiment of the invention.

The light emitting apparatus **1** is composed of a horizontal radiation type lens **5** that light emitted from the LED element **4** is radiated in the horizontal direction vertical to the optical axis, instead of the bullet-shaped lens **5** in the fourth embodiment. The horizontal radiation type lens **5** is integrally provided with a reflection plane **5**D that allows the total reflection of light emitted from the LED element **4**.

In the seventh embodiment, with the reflection plane **5**D to horizontally radiate light, the light extraction efficiency in the direction vertical to the optical axis can be enhanced and the convergence characteristic in the lateral direction of lens **5** can be enhanced. Thus, the light intensity in a predetermined horizontal lighting range can be increased.

This embodiment may be applied to a light emitting apparatus that radiates light through a converging optical system that is composed by combining a transmitting optical system and a reflecting optical system.

**[Eighth Embodiment]**

**FIG.12** is a cross sectional view showing a light emitting apparatus in the eighth preferred embodiment of the invention.

The light emitting apparatus **1** is composed of: an LED element **4** that is face-up bonded onto a board **6**; a reflection-type lens **5** that is of transparent resin such as silicon resin etc. and disposed around the LED element **4**; and a light shielding plate **9** that has a slit **9**A to allow the passing of light reflected by a reflection film **5**E of the lens **5.**

The lens **5** is formed having a semispherical inner shape, and an outer shape that is formed by rotating an ellipse which has the origin point of LED element **4** and the center point of slit **9**A or **9**B as its focal points and has the reflection film **5**E of aluminum etc. to be formed on its outer surface by known film formation method such as sputtering.

Further, the lens **5** has a LED housing recess **50** to house the LED element **4** with the board **6**, and the LED housing recess **50** has a tip portion shaped like a dome. The tip portion has a thin phosphor layer **5**A formed on its surface.

Light emitted from the LED element **4** is entered into the lens **5** through the phosphor layer **5**A. Light transmitting through the lens **5** is then reflected on the reflection film **5**E, radiated out of the lens **5** through the slits **9**A.

In the eighth embodiment, even when light transmits through the lens **5** and is reflected on the reflection film **5**E to be radiated through the slits **9**A, an excellent convergence characteristic can be obtained because the light source is downsized.

Although in the above embodiments the LED housing recess **50** is formed in the lens **5,** the LED housing recess **50** may be formed in a transparent member other than the lens **5.** In this case, the converging optical system can be composed by integrating the transparent member with the lens **5.**

**[Ninth Embodiment]**

**FIG.13** is a cross sectional view showing a light emitting apparatus in the ninth preferred embodiment of the invention.

In the following explanations, it is defined that the center axis of light emitting element is a Z-axis, a point on the upper surface crossed by the Z-axis is an origin point, and a coordinate system is provided with an X-axis and a Y-axis to intersect the Z-axis at the origin point. Like components are indicated by the same numerals used in the previous embodiments and its explanations are omitted below.

The light emitting element **81** is composed of: a board **6** that includes an insulation layer **6**A, a base member **6**B of an excellent thermal conductivity material such as aluminum etc., and wiring patterns **3**A, **3**B formed on the insulation layer **6**A; an LED element **4** that is face-up bonded onto the wiring pattern **3**A; bonding wires **7** that offer the electrical connection between the electrodes (not shown) of LED element **4** and the lead frames **3**A, **3**B; and an optical system **85** that is bonded to the board **6** while surrounding the LED element **4** and bonding wires **7**.

The wiring patterns **3**A, **3**B are formed by etching a copper foil layer bonded through the insulation layer **6**A onto the base member **6**B to offer a predetermined circuit pattern. They are provided with a concave portion, which is formed by etching, to engage with a convex portion formed on the optical system **85**.

The LED element **4** is of a gallium nitride system compound semiconductor such as GaN, GaAlN, InGaN, InGaAlN etc. or ZnSe and emits blue series light with a wavelength of **450** to **480** nm. The LED element **4** mainly emits light from its electrode forming surface and side face, and it has a chip size of **300**x**300** μm. The device structure of blue LED is well known and its explanation is omitted herein.

The optical system **85** is formed by injection-molding a transparent resin such as polycarbonate resin with a relatively high refractive index. It is composed of: a first optical system **51** that is disposed surrounding the LED element **4** to converge light in the nearly horizontal X-axis direction vertical to the Z-axis and ; a second optical system **52** that is formed integrated with the first optical system **51** to radiate light in the nearly horizontal direction vertical to the Z-axis based on the total reflection; a LED housing recess **50** that is formed like a recess at the bottom of first optical system **51** to house the LED element **4** and bonding wires **7.** The LED housing recess **50** has such a shape and size that a gap **5**B between the LED housing recess **50** and the LED element **4** can be minimized.

The optical system **85** is bonded positioned at a predetermined position to the board **6** on which the LED element **4** is mounted. Although not shown, the positioning is conducted such that the concave portions on the board **6** are engaged with the convex portions on the optical system **85.** Alternatively, another positioning method may be used.

The first optical system **51** is disposed surrounding the LED element **4** such that light is refracted in the direction vertical to the optical axis Z. It has a convex plane that allows radiation light of about **55** to **90** degrees to the Z-axis to be radiated refracted in the direction vertical to the Z-axis. Namely, the convex plane is shaped by rotating around the Z-axis an ellipse that has a symmetrical axis on the X-axis, a distance $D_1$ from its origin point to elliptic center, a diameter $n*D_1$ in the X-axis direction and a diameter $\sqrt{n^2 - 1} * D_1$. n is a refractive index of lens material. In case of epoxy resin and polycarbonate resin, $n \cong$ **1.5.** $D_1$ is an arbitrary value to determine a homothetic ratio.

The second optical system **52** has a circular reflection plane formed such that part of a parabola symmetrical to the X-axis and having the origin point of LED element **4** as its focal point is rotated **360** degrees around the Z-axis. It has an upper reflection plane **85**D provided in an angle range of within **55** degrees to the Z-axis, and a side radiation face **85**E that defines a column-like shape around the Z-axis and that light subjected to the total reflection by the upper reflection plane **85**D is radiated in the side direction. According to use, the second optical system **52** may be provided with a flat plane at its center that allows the extraction of light in the direction of Z-axis.

The first optical system **51** and second optical system **52** are each other in position and dimension relationships such that, as shown in **FIG.13**, all lights emitted from the LED element **4** and radiated in the direction of within **90** degrees to the Z-axis can reach the lens face of first optical system **51** or the upper reflection plane **85**D of second optical system **52** and light reflected on the upper reflection plane **85**D can reach the side radiation face **85**E (in the Z-axis direction, the bottom of upper reflection plane **85**D is located above the top end of lens face of first optical system **51).** Therefore, the diameter of second optical system **52** should be greater than that of first optical system **51**.

In manufacturing the light emitting apparatus **81**, a board **6** with a copper foil layer formed on the surface is etched to form the wiring patterns **3**A, **3**B. Then, the LED element **4** is face-up bonded onto the surface of wiring pattern **3**A. Then, the electrodes (not shown) of LED element **4** are electrically connected through the bonding wires **7** to the wiring patterns **3**A, **3**B.

The optical system **85** is made in separate process. First, by filling transparent resin in a split mold with the shape of optical system **85** (lens), the optical system **85** with the LED housing recess **50** is made by injection-molding. In process of injection molding, the concave portions for positioning are simultaneously molded.

Then, the optical system **85** is positioned such that the convex portions are engaged with the concave portions on the wiring patterns **3**A, **3**B. At that time, the LED housing recess **50** is filled with transparent silicon resin injected thereinto. Then, the optical system **85** is fixed on the wiring patterns **3**A, **3**B while sealing the LED element **4** with silicon resin.

The operation of the light emitting apparatus of the ninth embodiment will be described below.

A drive section (not shown) applies a drive voltage to the wiring patterns **3**A, **3**B. The LED element **4** emits blue light based on the drive voltage. Blue light emitted from the LED element **4** is irradiated to the upper reflection plane **85**D of second optical system **52** in a range of less than about **60** degrees from the Z-axis, subjected to the total reflection on the upper reflection plane **85**D, entered vertically into the side radiation face **85**E, radiated out of the optical system **85** in the direction vertical to the Z-axis. On the other hand, light in a range of about **60** to **90** degrees from the Z-axis is converged by the first optical system **51** and then radiated in the direction vertical to the Z-axis. Thus, nearly all blue lights emitted from the LED element **4** are externally radiated in the direction vertical to the Z-axis based on the total reflection and lens convergence.

The effects obtained in the ninth embodiment are as follows.

(**1**) The thickness of light source (composed of LED element **4** and optical system **85**) to its diameter can be thinned.

(**2**) Although a deviation in light distribution characteristics of light source caused by an axis misalignment between light source and lens element (as in prior art **2**) or a misalignment between LED element **4** and optical system **85** becomes significant according as the degree of convergence increases, it can be prevented fundamentally. Therefore, the distribution characteristics of light radiated in the lateral direction can be stabilized.

(**3**) The radiation efficiency in the lateral direction can be enhanced. Because, as described above, nearly all lights emitted from the LED element **4** are externally radiated in the direction vertical to the Z-axis based on the total reflection and lens convergence.

(**4**) An incident angle of light entering into the first optical system **51** from the LED element **4** and an incident angle of light entering into the side radiation face **85**E can be controlled to be **35** degrees or less to reduce the interface reflection coefficient by using a material of n=**1.5** for them (except for the upper reflection plane **85**D to use the total reflection). Thereby, loss in interface reflection can be reduced. Further, since the basic optical system can optically control nearly all lights radiated from the LED element **4**, the radiation efficiency does not lower or a reduction ratio of radiation efficiency can be lowered even when the diameter is reduced.

(**5**) Since the first optical system **51** and second optical system **52** to produce the lateral radiation are integrally structured, a misalignment of optical system to LED element **4** due to a physical shock is unlikely to occur. Also, the number of parts or assembly steps does not increase. Further, a deviation in assembly precision does not increase.

The first optical system **51** can be formed being at an angle of up to $\theta = \sin^{-1}(\mathbf{1}/n)$ to the Z-axis, though there is a slight influence on interface reflection. In case of n=**1.5**, it can be formed up to about **40** degrees to the Z-axis. In order to optically control nearly all light fluxes radiated from the LED element **4**, it is necessary to form a reflection plane that covers about **40** degrees from the LED element **4** to the Z-axis. In general, the range of about **40** degrees to the Z-axis is a region that has a relatively large radiation intensity from the LED element **4**. It is advantageous in external radiation efficiency to cover widely that region with the reflection plane. Namely, the first optical system **51** has a limited angle range where it can conduct the optical control, and according as the first optical system **51** is enlarged, loss in interface reflection is likely to occur at its end portion (high position in the Z-axis direction).

The first optical system **51** is not limited to a system to externally radiate parallel lights in the direction vertical to the Z-axis. For example, it may be a system to radiate lights converged in a range of about **30** degrees. In this case, the first optical system **51** may be formed up to about **35** degrees to the Z-axis, where the interface reflection is not so large.

When it is subjected to the interface reflection, it can be formed up to about **20** degrees to the Z-axis. In this case, a reflection plane to be formed is about **35** degrees and about **20** degrees to the Z-axis. However, since an edge is in molding difficult to form at discontinuous part of optical surface and a molding precision may lower due to occurrence of sink, it is desired that a range with a large radiation intensity from the LED element **4** is widely covered with a reflection plane. Therefore, the reflection mirror is preferably formed up to **40** degrees or more to the Z-axis.

Similarly to the first optical system **51**, the second optical system 52 may conduct the converged radiation in a certain width.

Although in the ninth embodiment the LED element **4** to radiate blue light is used, the LED element **4** to radiate red, green or ultraviolet light other than blue light may be used. The LED element **4** may be a large chip (e.g., **1000**x**1000** μm) of high-output type. The distance of LED element **4** and upper reflection plane **85**D is relatively long and more than half of the radius of optical system **85.** Therefore, even in case of a large LED element **4** or in case of a large light source that yellow phosphor to radiate yellow light when excited by blue light radiated from the LED element **4** is disposed around the LED element **4** to radiate white light by mixing blue light and yellow light, the total reflection of upper reflection plane 85D can be used.

The optical system **85** may be not transparent and colorless and may be colored. Although the converged radiation of nearly parallel lights in the direction vertical to the Z-axis is explained above, light may be externally radiated in a predetermined circular range. Alternatively, light may be externally radiated in a certain width, not nearly parallel lights, in the direction nearly vertical, more than **45** degrees, to the Z-axis.

## [Tenth Embodiment]

**FIG.14** is a cross sectional view showing a light emitting apparatus in the tenth preferred embodiment of the invention.

The light emitting apparatus **81** is, different from that in the ninth embodiment, composed of: an LED element **4** that is a large chip of **1000**x**1000** μm being flip-chip bonded through the bumps **4**A; a LED housing recess **50** that houses the LED element **4;** and a phosphor layer **5**A that is of Ce:YAG (yttrium aluminum garnet) to radiate yellow light when excited by blue light radiated from the LED element **4** and is thinly formed on the surface of LED housing recess **50.** The LED housing recess **50** has such a shape and size that a gap **5**B between the LED housing recess **50** and the LED element **4** can be minimized.

In the tenth embodiment, since the LED housing recess **50** with phosphor layer **5**A formed on the surface surrounds the LED element **4,** white light can be radiated.

With the phosphor layer **5**A formed uniformly and thinly, the lowering of light intensity due to light absorption can be prevented. Further, even when a large size LED element **4** is used, a high radiation efficiency and a good convergence characteristic can be secured while suppressing the enlargement of light source size caused by covering the light source with phosphor layer **5**A.

## [Eleventh Embodiment]

**FIG.15**A is a cross sectional view showing part (the vicinity of first optical system **51**) of a light emitting apparatus in the eleventh preferred embodiment of the invention. **FIG.15**B is a cross sectional view cut along the line D-D in **FIG.15**A.

The light emitting apparatus **81** is composed of: leads **2**A, **2**B that are of conductive material such as copper alloy and serve as a power supplying portion to mount a large size LED element **4**; a submount **3** that is provided on the LED-mounting side of leads **2**A, **2**B and has wiring patterns **3**A, **3**B provided on its surface; and the LED element **4** that is flip-chip mounted through bumps **4**A onto the wiring patterns **3**A, **3**B.

The submount **3** is of a material with high thermal conductivity, such as AlN. The LED element **4** is flip-chip bonded through the bumps **4**A onto the wiring patterns **3**A and **3**B formed on the submount **3.** The wiring pattern **3**A is electrically connected through a viahole (not shown) to the lead **2**A, and the wiring pattern **3**B is electrically connected through a viahole (not shown) to the lead **2**B.

The optical system **85** is positioned at a predetermined position by means of concavity-convexity engagement, with regard to the leads **2**A, **2**B with the LED element **4** mounted thereon. The LED housing recess **50** has a phosphor layer **5**A thinly formed on its surface. The LED housing recess **50** is, as shown in **FIG.15**B, structured such that a gap **5**B between the LED housing recess **50** and LED element **4** can be minimized.

In manufacturing the light emitting apparatus **81** thus composed, the leads **2**A, **2**B are formed by punching a metal member. In the process of forming the leads **2**A, **2**B by punching, the concave portions for positioning are simultaneously formed by indentation method. Then, the submount **3** of a high thermal conductivity material is disposed on the device-mounting side of leads **2**A, **2**B. Then, the circuit patterns **3**A, **3**B of copper foil is formed on the surface of submount **3.** Then, the LED element **4** is flip-chip bonded through the bumps **4**A to the circuit patterns **3**A, **3**B while being positioned at a predetermined position thereof.

The optical system **85** is made in separate process. First, by filling transparent resin in a mold with a shape of the optical system **85**, the optical system **85** with the first optical system **51**, second optical system **52** (not shown) and LED housing recess **50** is made by injection-molding. In the process of injection molding, the concave portions for positioning are simultaneously molded. Then, the phosphor layer **5**A is formed on the surface of LED housing recess **50** by coating thinly phosphor material.

Then, the optical system **85** is positioned such that the convex portions are engaged with the concave portions on the leads **2**A, **2**B. At that time, the LED housing recess **50** is filled with transparent silicon resin injected thereinto. Then, the optical system **85** is fixed on the leads **2**A, **2**B while sealing the LED element **4** with silicon resin.

In the eleventh embodiment, since the large-sized LED element **4** is mounted on the wiring patterns **3**A, **3**B formed on the submount **3**, heat from the LED element **4** when turned on can be rapidly and efficiently radiated through the leads **2**A, **2**B. Therefore, the light emitting apparatus can be sufficiently applied to a high-output type LED **4** and can be stably operated while suppressing a thermal shrinkage in the LED housing recess **50**. Thus, the reliability thereof can be enhanced.

Meanwhile, the LED element **4** may have a chip size of **300**x**300** μm. In this case, by the downsizing of light source, the convergence characteristic can be enhanced to increase the light intensity in a desired lighting range.

**[Twelfth Embodiment]**

**FIG.16** is a cross sectional view showing the LED housing recess **50** of a light emitting apparatus in the twelfth preferred embodiment of the invention.

The optical system **85** has the LED housing recess **50** that is shaped rectangular like the LED element **4**.

In the twelfth embodiment, since the gap **5**B between the LED element **4** and phosphor layer **5**A is further narrowed, the enlargement of light source size can be prevented further effectively and, thereby, the convergence characteristic of light radiated can be further enhanced.

**[Thirteenth Embodiment]**

**FIG.17**A is a cross sectional view showing part (the vicinity of first optical system **51**) of a light emitting apparatus in the thirteenth preferred embodiment of the invention. **FIG.17**B is a cross sectional view cut along the line E-E in **FIG.17**A.

The light emitting apparatus **81** is composed of a red LED element **40** and blue LED elements **41** that are flip-chip bonded onto wiring patterns **3**A, **3**B and **3**C.

As shown in **FIG.17**B, the eight blue LED elements **41** are disposed around the red LED element **40.** The red LED element **40** and blue LED elements **41** have a chip size of **300**x**300** μm.

The phosphor layer **5**A is of Ce:YAG that radiates yellow light when excited by blue light emitted from the blue LED element **41**.

In the thirteenth embodiment, like the ninth embodiment, white light can be obtained by that blue light emitted from the blue LED element **41** is mixed with yellow light radiated from the phosphor layer **5**A being excited by the blue light. In addition, in this embodiment, white light with a high color rendering property can be obtained by adding red light emitted from the red LED element **40** thereto.

Alternatively, ultraviolet LED elements **41** may be disposed around the red LED element **40** instead of blue LED element **41.** Ultraviolet light emitted from the ultraviolet LED elements **41** is entered into the phosphor layer **5**A with red, blue and green phosphors mixed therein and, thereby, white light can be radiated therefrom. Furthermore, nine ultraviolet LED elements **41** may be disposed without using the red LED element **40.**

**[Fourteenth Embodiment]**

**FIG.18** is a cross sectional view showing a light emitting apparatus in the fourteenth preferred embodiment of the invention.

The light emitting apparatus **81** is composed of the second optical system **52** provided with a stepwise portion **85**F.

In the fourteenth embodiment, the resin layer of optical system **85** can be formed in nearly equal thickness. Thereby, the molding property can be enhanced and a profile distortion in optical surface that may occur by sink etc. can be reduced. Further, the producibility can be enhanced since the cooling time of thick resin portion can be eliminated. The amount of resin required can be reduced and the manufacturing cost can be reduced.

The stepwise portion **85**F is not limited to the shape and number of steps as shown in **FIG.18.**

The light emitting apparatus **81** may use a LED element **4** to be flip-chip bonded onto the wiring patterns **3**A, **3**B. Further, it may use a large-size LED element **4** to increase the light intensity.

**[Fifteenth Embodiment]**

**FIG.19**A is a top view showing a light emitting apparatus in the fifteenth preferred embodiment of the invention. **FIG.19**B is a cross sectional view cut along the line F-F in **FIG.19**A.

In this embodiment, the light emitting apparatus **81** is composed such that the optical system **85** in the tenth embodiment (**FIG.14**) is composed of only the second optical system **52** while omitting the first optical system **51**, and the optical system **85** is, as shown by cross section in **FIG.19**B, provided with a plurality of stepwise circular reflection portions **85**G on the bottom side (on the side of board **6**). The reflection portions **85**G have an inclined angle of **45** degrees. The optical system **85**, as shown in **FIG.19**B, has a surface that defines a parabolic cross section in region a close to LED **4** and defines a flat plane in region b outer than region a.

In operation, light emitted from LED **4** is mainly reflected in the direction parallel to the center axis of LED **4** by the reflection portions **85**G. Since the optical system **85** has the parabolic plane in cross section in region a, light component emitted in the Z-axis direction is reflected horizontally on the parabolic plane in region a and is then reflected vertically on the reflection portions **85**G, as shown in **FIG.19**B.

In the fifteenth embodiment, since the optical system **85** has the parabolic plane in region a close to LED **4** and the circular reflection portions **85**G, light component emitted near the center axis of LED **4** can be diffused in the radial direction of optical system **85**. Therefore, the light intensity can be equalized.

**[Sixteenth Embodiment]**

**FIG.20**A is a top view showing a light emitting apparatus in the sixteenth preferred embodiment of the invention. **FIG.20**B is a cross sectional view cut along the line G-G in **FIG.20**A.

In this embodiment, the light emitting apparatus **81** is, different from the optical system **85** in the fifteenth embodiment, composed of an optical system **85** that is provided with three reflection portions **85**H, on the bottom side, which are disposed at intervals of predetermined angle (in this embodiment, **360/7** degrees) in the circumference direction and which are disposed at different positions each other in the radial direction. The reflection portions **85**H have an inclined angle of **45** degrees. The optical system **85,** as shown in **FIG.20**B, has a surface that defines a parabolic cross section in region a close to LED **4** and defines a flat plane in region b outer than region a.

In the sixteenth embodiment, since the three reflection portions **85**H disposed at different positions in the radial direction are continuously disposed in the circumference direction of optical system **85**, the brightness varies at different positions and thereby it looks glittering. Further, since the optical system **85** has the parabolic plane in region a close to LED **4** and the reflection portions **85**H, light component emitted near the center axis of LED **4** can be diffused in the radial direction of optical system **85**. Therefore, the light intensity can be equalized.

Although the invention has been described with respect to the specific embodiments for complete and clear disclosure, the appended claims are not to be thus limited but are to be construed as embodying all modifications and alternative constructions that may occur to one skilled in the art which fairly fall within the basic teaching herein set forth.

A light emitting apparatus has: a semiconductor light emitting element that emits light with a predetermined wavelength; a light-transmitting portion that has a recess to house the semiconductor light emitting element, the light-transmitting portion being of a light-transmitting material and the recess being formed by molding the light-transmitting material; and a phosphor layer portion that is thinly formed along the surface of the recess, the phosphor portion having a phosphor to be excited by irradiating light emitted from the semiconductor light emitting element.

**Claims**

**1.** A light emitting apparatus, comprising:

a semiconductor light emitting element that emits light with a predetermined wavelength;
a light-transmitting portion that includes a recess to house the semiconductor light emitting element, the light-transmitting portion being of a light-transmitting material and the recess being formed by molding the light-transmitting material; and
a phosphor layer portion that is thinly formed along the surface of the recess, the phosphor portion including a phosphor to be excited by irradiating light emitted from the semiconductor light emitting element.

**2.** The light emitting apparatus according to claim **1**, wherein:

the light-transmitting portion has a light convergence shape to converge light emitted from the light emitting element.

**3.** The light emitting apparatus according to claim **1 or** 2, wherein:

the semiconductor light emitting element is a flip-chip type LED element that emits light from its light emission surface located on the opposite side of its mounting surface.

**4.** The light emitting apparatus according to any one of claims **1 to 3**, wherein:

the recess is located close to the semiconductor light emitting element along the profile of the semiconductor light emitting element.

**5.** The light emitting apparatus according to any one of claims **1 to 4,** wherein:

the semiconductor light emitting element is composed of a plurality of LED elements disposed in a predetermined arrangement.

**6.** The light emitting apparatus according to any one of claims **1 to 5**, wherein:

the semiconductor light emitting element is composed of a plurality of LED elements with different emission wavelengths disposed in a predetermined arrangement.

**7.** A method of making a light emitting apparatus, comprising the steps of:

preparing a light-transmitting portion that includes a recess to house a semiconductor light emitting element, the light-transmitting portion being of a light-transmitting material and the recess being formed by molding the light-transmitting material, the recess being provided with a phosphor layer that is thinly formed along the surface of the recess;
forming an electrode of metal material;
mounting the semiconductor light emitting element on the electrode;
positioning the light-transmitting portion to the electrode; and
bonding the light-transmitting portion onto the electrode such that the phosphor layer of the recess surrounds the semiconductor light emitting element.

**8.** The method according to claim **7**, wherein:

the phosphor layer is formed by spraying a phosphor material on the surface of the recess after forming the recess by molding.

**9.** The method according to claim **7 or 8**, wherein:

the electrode is a lead electrode provided on the surface of a submount member of high thermal conductivity.

**10.** The method according to any one of claims **7 to 9**, wherein:

the electrode is a copper-foil electrode provided through an insulation layer on the surface of a base member of high thermal conductivity.

**11.** The method according to any one of claims **7 to 10**, wherein:

the semiconductor light emitting element is flip-chip bonded onto the electrode.

**12.** A light emitting apparatus, comprising:

a light emitting element;
a power supply portion to supply electric power to the light emitting element;
a first optical system that is formed in a range of a predetermined angle to the center axis of the light emitting element when determining the center of emission surface of the light emitting element as origin point; and
a second optical system that includes a reflection plane disposed facing the emission surface of the light emitting element and a radiation face to externally radiate light being emitted from the light emitting element and then reflected on the reflection plane;

wherein the first optical system and the second optical system are disposed such that light being emitted from the light emitting element is externally radiated in the direction vertical to the center axis of the light emitting element.

**13.** The light emitting apparatus according to claim **12**, wherein:

the predetermined angle is greater than **40** degrees.

**14.** The light emitting apparatus according to claim **12 or 13**, wherein:

the first optical system and the second optical system optically control nearly all amount of light being emitted from the light emitting element to be externally radiated.

**15.** The light emitting apparatus according to claim **12**, wherein:

the first optical system and the second optical system are of a material with a refractive index of about **1.5,** and an incident angle of light to enter to the first optical system from the light emitting element and an incident angle of light reflected on the reflection plane to enter the radiation face from the light emitting element are **35** degrees or less.

**16.** The light emitting apparatus according to any one of claims **12 to 15**, wherein:

the second optical system includes: an upper circular reflection plane that is formed such that part of a parabola symmetrical to an axis vertical to the center axis and having the center of emission surface of the light emitting element as its focal point is rotated **360** degrees around the center axis; and a side radiation face that radiates light subjected to total reflection by the upper reflection plane in the lateral direction.

**17.** The light emitting apparatus according to any one of claims **12 to 16**, wherein:

the second optical system allows part of light emitted from the light emitting element to be externally radiated as nearly parallel light in the direction vertical to the center axis of the light emitting element.

**18.** The light emitting apparatus according to any one of claims **12 to 17**, wherein:

the first optical system includes a recess to house the light emitting element, the recess being located close to the semiconductor light emitting element along the profile of the semiconductor light emitting element.

**19.** The light emitting apparatus according to any one of claims **12 to 18,** wherein:

the light emitting element is composed of a plurality of light emitting elements disposed in a predetermined arrangement.

**20.** The light emitting apparatus according to any one of claims **12 to 19,** wherein:

the light emitting element is composed of a plurality of light emitting elements with different emission wavelengths disposed in a predetermined arrangement.

**21.** A method of making a light emitting apparatus, comprising the steps of:

forming a power supply portion;
mounting a light emitting element on the power supply portion;
positioning an optical system to the power supply portion, the optical system being composed of a first optical system that includes a recess to house the light emitting element and a convergence surface to converge light emitted from the light emitting element and then radiate it in the direction vertical to the center axis of the light emitting element, and a second optical system that includes a reflection plane to allow the total reflection of light emitted from the light emitting element and then radiate it in the direction vertical to the center axis of the light emitting element; and
bonding the optical system onto the power supply portion such that the light emitting element is surrounded by the recess.

**22.** The method according to claim **21,** wherein:

the first optical system includes a phosphor layer that is thinly formed by spraying a phosphor material on the surface of the recess after forming the recess by molding.

**23.** The method according to claim **21 or 22,** wherein:

the bonding step is conducted after injecting transparent sealing resin into the recess.

**24.** A light emitting apparatus, comprising:

a light emitting element;
a power supply portion to supply electric power to the light emitting element; and
an optical system that includes a recess to house the light emitting element, a light-guiding portion to guide light emitted from the light emitting element in the direction vertical to the center axis of the light emitting element, and a reflection portion to reflect light being guided through the light-guiding portion in the direction vertical to the center axis and then radiate it in the direction parallel to the center axis.

**25.** The light emitting apparatus according to claim **24,** wherein:

the optical system includes an overlying reflection portion by which light emitted from the light emitting element in the direction nearly over the light emitting element is reflected in the direction vertical to the center axis.

FIG. 1A PRIOR ART

30
LIGHT
EMITTING
APPARATUS
35
SEALING
PORTION
33
LED
34
36
EPOXY
RESIN
32
34
BONDING
WIRE
31A
LEAD
FRAME
31B
LEAD
FRAME

FIG. 1B PRIOR ART

35
35B
PHOSPHOR
LAYER
35A
TRANSPARENT
SPACER
34
34
33
32
31B

FIG.2 PRIOR ART

35B
PHOSPHOR
LAYER
33
LED
36
EPOXY
RESIN
34
34
BONDING
WIRE
37
SUBSTRATE
35A
TRANSPARENT
SPACER

FIG.3A PRIOR ART

L
38
CONVERGING
OPTICAL
SYSTEM
39
LIGHT
SOURCE

FIG.3B PRIOR ART

L
38
39

FIG.4A PRIOR ART

Z
X
73
OPTICAL
ELEMENT
73A
64
FIRST
REFLECTION
REGION
66
SECOND
REFLECTION
REGION
B
64A
67
68
EDGE
65
A
66
67
69
66B
66A
72
LENS
ELEMENT
C
61
63
C
70
60
LED
71
61A
62

FIG.4B PRIOR ART

Y
X
62
LIGHT
SOURCE
62B
RECESS
70
62A
71
POST
61
DOME
61A

FIG.5A
1
LIGHT
EMITTING
APPARATUS
50
LED
HOUSING
RECESS
5A
PHOSPHOR
LAYER
5
LENS
3B
WIRING
PATTERN
3A
WIRING
PATTERN
2B
LEAD
3
SUBMOUNT
4
LED
2A
LEAD

FIG.5B
1
5
50
5A
A
A
3B
3A
3
4A
4
4A
BUMP
2A

FIG.5C
5A
50
4
5
5B

FIG. 6

5A
PHOSPHOR
LAYER
50
LED
HOUSING
RECESS
4
LED
5
LENS
5B
GAP

FIG.7A
1
LIGHT
EMITTING
APPARATUS
50
LED
HOUSING
RECESS
5A
PHOSPHOR
LAYER
5
LENS
3B
WIRING
PATTERN
3A
WIRING
PATTERN
3
SUBMOUNT
41
40
RED
LED
41
BLUE
LED
2
LEAD
4
LED

FIG.7B
41 5A 40 41 50
1
5
B
B
3B
3A
2
3
4A
4A
BUMP
3C
WIRING
PATTERN

FIG.7C
40
RED
LED
50
41
BLUE
LED
5
5A
5B

FIG.8A

50
LED
HOUSING
RECESS
1
LIGHT
EMITTING
APPARATUS
5A
PHOSPHOR
LAYER
5
LENS
3B
WIRING
PATTERN
3A
WIRING
PATTERN
6
BOARD
4
LED

FIG.8B

50
5A
1
5
3B
3A
6A
INSULATION
LAYER
4A
BUMP
4
4A
6B
BASE
MEMBER
6

FIG. 9

50
LED
HOUSING
RECESS
1
LIGHT
EMITTING
APPARATUS
5A
PHOSPHOR
LAYER
5
LENS
3B
WIRING
PATTERN
3A
WIRING
PATTERN
7
BONDING
WIRE
4
LED
6
BOARD

FIG. 10

1
LIGHT
EMITTING
APPARATUS
8
CAP
5A
PHOSPHOR
LAYER
5C
GAP
50
LED
HOUSING
RECESS
3B
WIRING
PATTERN
3A
WIRING
PATTERN
7
4
6

FIG. 11

1
LIGHT
EMITTING
APPARATUS
5D
REFLECTION
PLANE
5D
5A
PHOSPHOR
LAYER
3B
WIRING
PATTERN
5
LENS
3A
WIRING
PATTERN
50
LED
HOUSING
RECESS
4
LED
6
BOARD

FIG. 12

50
LED
RECESS
9
LIGHT
SHIELDING
PLATE
9A
9A
SLIT
5
LENS
6
BOARD
5E
REFLECTION
FILM
1
LIGHT
EMITTING
APPARATUS
7
7
BONDING
WIRE
4
LED
5A
PHOSPHOR
LAYER

FIG. 13
81 LIGHT EMITTING APPARATUS
85D UPPER REFLECTION PLANE
85E SIDE RADIATION FACE
52 SECOND OPTICAL SYSTEM
3A WIRING PATTERN
6B BASE MEMBER
L
X
Y
Z
7 BONDING WIRE
4 LED
7 BONDING WIRE
5B GAP
50 LED HOUSING RECESS
85D UPPER REFLECTION PLANE
85E SIDE RADIATION FACE
51 FIRST OPTICAL SYSTEM
3B WIRING PATTERN
6A INSULATION LAYER
6 BOARD
L
85 OPTICAL SYSTEM

FIG. 14
81 LIGHT EMITTING APPARATUS
85D UPPER REFLECTION PLANE
85E SIDE RADIATION FACE
52 SECOND OPTICAL SYSTEM
3A WIRING PATTERN
6A INSULATION LAYER
L
X
Y
Z
4A BUMP
4 LED
4A
50 LED HOUSING RECESS
6B BASE MEMBER
6 BOARD
5A PHOSPHOR LAYER
85D UPPER REPLECTION PLANE
85E SIDE RADIATION FACE
51 FIRST OPTICAL SYSTEM
3B WIRING PATTERN
L
85 OPTICAL SYSTEM

FIG. 15A

50
LED
HOUSING
RECESS
85
OPTICAL
SYSTEM
Z
5A
PHOSPHOR
LAYER
Y
51
1
LIGHT
EMITTING
APPARATUS
3B
WIRING
PATTERN
D
D
X
3A
WIRING
PATTERN
2B
LEAD
3
SUBMOUNT
4A
4
4A
BUMP
2A
LEAD

FIG. 15B

5A
PHOSPHOR
LAYER
50
4
LED
85
5B
GAP

FIG. 16

5A
PHOSPHOR
LAYER
50
LED
HOUSING
RECESS
4
LED
5
LENS
5B
GAP

FIG. 17A

41 BLUE LED
5A PHOSPHOR LAYER
Z
Y
40 RED LED
41
50 LED HOUSING RECESS
81 LIGHT EMITTING APPARATUS
85
3B WIRING PATTERN
E
E
X
3A WIRING PATTERN
2B LEAD
3 SUBMOUNT
4A
4A BUMP
3C WIRING PATTERN
2A LEAD


FIG. 17B

40 RED LED
50
41 BLUE LED
85
5A
5B GAP

FIG. 18
81 LIGHT EMITTING APPARATUS
85E SIDE RADIATION FACE
85D UPPER REFLECTION PLANE
52 SECOND OPTICAL SYSTEM
85F STEPWISE PORTION
3A WIRING PATTERN
6A INSULATION LAYER
Z
Y
X
7 BONDING WIRE
4 LED
50 LED HOUSING RECESS
L
85F
51 FIRST OPTICAL SYSTEM
3B WIRING PATTERN
6B BASE MEMBER
6 BOARD

FIG. 19A

85
OPTICAL
SYSTEM
F
F
50
LED
HOUSING
RECESS

FIG. 19B

81
LIGHT
EMITTING
APPARATUS
L
Z
a
b
b
85
Y
85G
X
3A
WIRING
PATTERN
3B
WIRING
PATTERN
6A
INSULATION
LAYER
6B
BASE
MEMBER
50
4A
4
LED
4A
BUMP
6
BOARD

FIG.20A

85
OPTICAL
SYSTEM
85H
85H
85H
85H
G
G
50
LED
HOUSING
RECESS

FIG.20B

81
LIGHT
EMITTING
APPARATUS
L
Z
a
b
b
85
85H
85H
Y
85H
X
3A
WIRING
PATTERN
50
4
LED
4A
BUMP
6A
INSULATION
LAYER
6
BOARD